(19) **Europäisches Patentamt / European Patent Office / Office européen des brevets**

(11) **EP 4 786 997 A1**

(12) **EUROPEAN PATENT APPLICATION**
published in accordance with Art. 153(4) EPC

(43) Date of publication:
05.08.2026 Bulletin 2026/32

(21) Application number: 25858022.4

(22) Date of filing: 28.03.2025

(51) International Patent Classification (IPC):
$G01R\ 31/392^{(2019.01)}$    $G01R\ 31/367^{(2019.01)}$
$G01R\ 31/382^{(2019.01)}$    $G01R\ 31/385^{(2019.01)}$
$H01M\ 10/42^{(2006.01)}$    $H01M\ 10/48^{(2006.01)}$

(52) Cooperative Patent Classification (CPC):
G01R 31/367; G01R 31/382; G01R 31/385;
G01R 31/392; H01M 10/42; H01M 10/48

(86) International application number:
PCT/JP2025/012776

(87) International publication number:
WO 2026/069783 (02.04.2026 Gazette 2026/14)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.09.2024 JP 2024168772

(71) Applicant: Vehicle Energy Japan Inc.
Hitachinaka-shi, Ibaraki 312-8505 (JP)

(72) Inventors:
• SASAKI, Hironori
  Hitachinaka-shi, Ibaraki 312-8505 (JP)
• IMAI, Shinji
  Hitachinaka-shi, Ibaraki 312-8505 (JP)

(74) Representative: Mewburn Ellis LLP
Aurora Building
Counterslip
Bristol BS1 6BX (GB)

(54) **BATTERY CONTROL DEVICE AND VEHICLE CONTROL DEVICE**

(57) A battery control device 100 has a computation device (battery controller 101) that computes an SOHR of a battery 300 and a recording device 101b that records a plurality of SOHR recorded values associated with at least a temperature T and an SOC of the battery 300. The battery controller 101 estimates deterioration of the battery 300 on the basis of at least the SOHR. The battery controller 101 computes the plurality of SOHR recorded values on the basis of a deterioration estimation result of the battery 300. The battery controller 101 records the plurality of computed SOHR recorded values in the recording device 101b. The battery controller 101 computes the SOHR of the battery 300 on the basis of at least the temperature T and the SOC of the battery 300 and the plurality of SOHR recorded values recorded in the recording device 101b.

[FIG. 5]

EP 4 786 997 A1

# Description

Technical Field

The present invention relates to a battery control device and a vehicle control device.

Background Art

A technique for accurately estimating the state of a battery according to deterioration of the battery has been known from the past (see Patent Document 1).

Prior Art Document

Patent Document

Patent Document 1: JP-2008-241246-A

Summary of the Invention

Problem to be Solved by the Invention

In the control of a battery and a vehicle, it is required to more appropriately control the battery and the vehicle according to deterioration of the battery.

Means for Solving the Problem

A battery control device according to one aspect of the present inventio has a computation device that computes an SOHR of a secondary battery and a recording device that records a plurality of SOHR recorded values associated with at least a temperature and an SOC of the secondary battery. The computation device estimates deterioration of the secondary battery on the basis of at least the SOHR. The computation device computes the plurality of SOHR recorded values on the basis of a deterioration estimation result of the secondary battery. The computation device records the plurality of computed SOHR recorded values in the recording device. The computation device computes the SOHR of the secondary battery on the basis of at least the temperature and the SOC of the secondary battery and the plurality of SOHR recorded values recorded in the recording device.

A vehicle control device according to one aspect of the present invention is provided with the battery control device. The vehicle control device controls a vehicle having the secondary battery and electric equipment operated by electric power of the secondary battery.

Advantages of the Invention

According to the present invention, it is possible to more appropriately control a battery and a vehicle according to deterioration of the battery.

Brief Description of the Drawings

[Fig. 1] Fig. 1 is a diagram for depicting an outline configuration of a vehicle 1 mounted with a battery control device 100 according to a first embodiment.
[Fig. 2] Fig. 2 is a diagram for depicting an example of a hardware configuration of a vehicle control system mounted on the vehicle 1.
[Fig. 3] Fig. 3 is a functional block diagram of the battery control device 100.
[Fig. 4] Fig. 4 is a functional block diagram for depicting a first function of an SOHR computation section 115 according to the first embodiment.
[Fig. 5] Fig. 5 is a functional block diagram for depicting a second function of the SOHR computation section 115 according to the first embodiment.
[Fig. 6] Fig. 6 is a functional block diagram for depicting a second function of an SOHR computation section 215 according to a second embodiment.
[Fig. 7] Fig. 7 is a functional block diagram for depicting a second function of an SOHR computation section 315 according to a third embodiment.
[Fig. 8] Fig. 8 is a functional block diagram for depicting a second function of an SOHR computation section 415 according to a fourth embodiment.
[Fig. 9] Fig. 9 is a functional block diagram for depicting a second function of an SOHR computation section 515 according to a fifth embodiment.

Modes for Carrying Out the Invention

Embodiments for carrying out the present invention will be described with reference to the drawings.

[First Embodiment]

(Configuration of first embodiment)

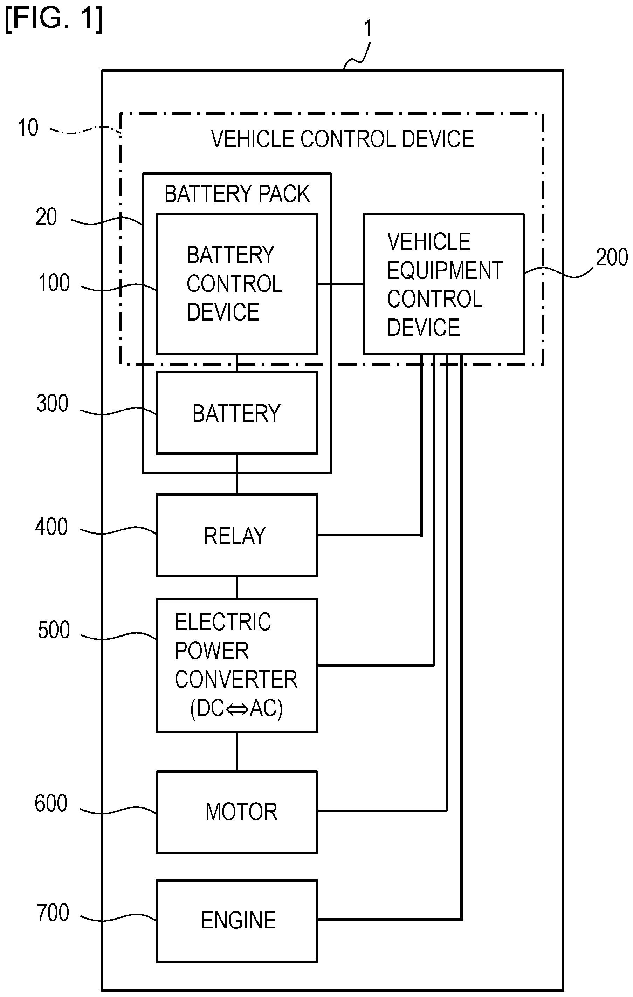

Configurations of a battery control device 100 and a vehicle control device 10 provided with the battery control device 100 of a first embodiment will be described with reference to Fig. 1.

Fig. 1 is a diagram for depicting an outline configuration of a vehicle 1 mounted with the battery control device 100 according to the first embodiment.

As depicted in Fig. 1, the vehicle 1 is configured with, for example, a hybrid electric vehicle. The hybrid electric vehicle is, for example, an HEV (Hybrid Electric Vehicle) or a PHEV (Plug-in Hybrid Electric Vehicle). Hybrid electric vehicles include a strong hybrid electric vehicle having an output voltage of, for example, several hundred volts and a mild hybrid electric vehicle having an output voltage of, for example, 48 volts. The vehicle 1 may be configured with an EV (Electric Vehicle).

In a case where the vehicle 1 is a hybrid electric vehicle, the vehicle 1 is provided with a motor 600 as electric equipment and an engine 700 as an internal combustion engine, which are used to drive the vehicle 1 to travel. Power generated by the motor 600 and the engine 700 is transmitted to tires via a power transmission mechanism. In a case where the vehicle 1 is an EV (Electric Vehicle), the vehicle 1 is not provided with the engine 700. Hence, the power generated by the motor 600 is transmitted to the tires via the power transmission mechanism. The motor 600 is operated by electric power from a battery pack 20 to generate power.

The vehicle 1 is provided with a vehicle control device 10, a battery 300, a relay 400, an electric power converter 500, the motor 600, and the engine 700. The vehicle control device 10 includes the battery control device 100 and a vehicle equipment control device 200. The battery pack 20 includes the battery control device 100 and the battery 300. The details of the vehicle control device 10 will be described later.

The battery 300 is configured with, for example, an assembled battery. The assembled battery is provided with a plurality of single batteries. The plurality of single batteries are connected in series, connected in parallel, or connected in series and in parallel by bus bars. The single battery is, for example, a secondary battery. The secondary battery is, for example, a lithium ion battery. It should be noted that the secondary battery may be configured with a device having an electric power storage function, such as a nickel hydrogen battery, an all-solid battery, a lead battery, and an electric double layer capacitor. In addition, the battery 300 is not limited to the case where it is configured with a plurality of secondary batteries, and may be configured with one secondary battery. The battery 300 is not limited to the case where it is configured with a plurality of secondary batteries, and may be configured with a primary battery. Electric power of the battery 300 is supplied to the motor 600 via the relay 400 and the electric power converter 500.

The relay 400 is electrically connected to the battery 300 and the electric power converter 500. The relay 400 energizes the motor 600 from the battery 300 and interrupts the energization of the motor 600 from the battery 300.

The electric power converter 500 transforms electric power while converting the electric power between a direct current (DC) and an alternating current (AC). The electric power converter 500 is electrically connected to the relay 400 and the motor 600. The electric power converter 500 includes an inverter circuit and a converter circuit.

The motor 600 performs a powering operation for generating a driving force and a regenerative operation for recovering energy, according to the travelling state of the vehicle 1. In the powering operation of the motor 600, the electric power converter 500 transforms electric power of the battery 300 while converting the electric power from a direct current to an alternating current, and supplies it to the motor 600. Accordingly, power is generated by the motor 600, and the vehicle 1 travels. In addition, in a case where the vehicle 1 travels by the power of the engine 700, the vehicle 1 accelerates by the power of the motor 600. In the regenerative operation of the motor 600, the electric power converter 500 transforms the electric power generated by the motor 600 while converting the electric power from an alternating current to a direct current, and supplies it to the battery 300. Accordingly, the battery 300 is charged.

The engine 700 is an example of an internal combustion engine. The engine 700 is used to drive the vehicle 1. The engine 700 is used as power of the tires of the vehicle 1. In the case where the vehicle 1 is an EV (Electric Vehicle), the engine 700 is not necessary.

Each of the battery control device 100 and the vehicle equipment control device 200 configuring the vehicle control device 10 is configured with an ECU (Electronic Control Unit). It should be noted that the vehicle control device 10 may be configured with one ECU provided with the functions of the battery control device 100 and the functions of the vehicle equipment control device 200. The battery control device 100 is also referred to as, for example, a battery management system (BMS).

The vehicle equipment control device 200 controls driving equipment of the vehicle 1 on the basis of battery information or the like output from the battery control device 100. The driving equipment of the vehicle 1 includes the relay 400, the electric power converter 500, the motor 600, and the engine 700.

(Hardware configuration of vehicle control system)

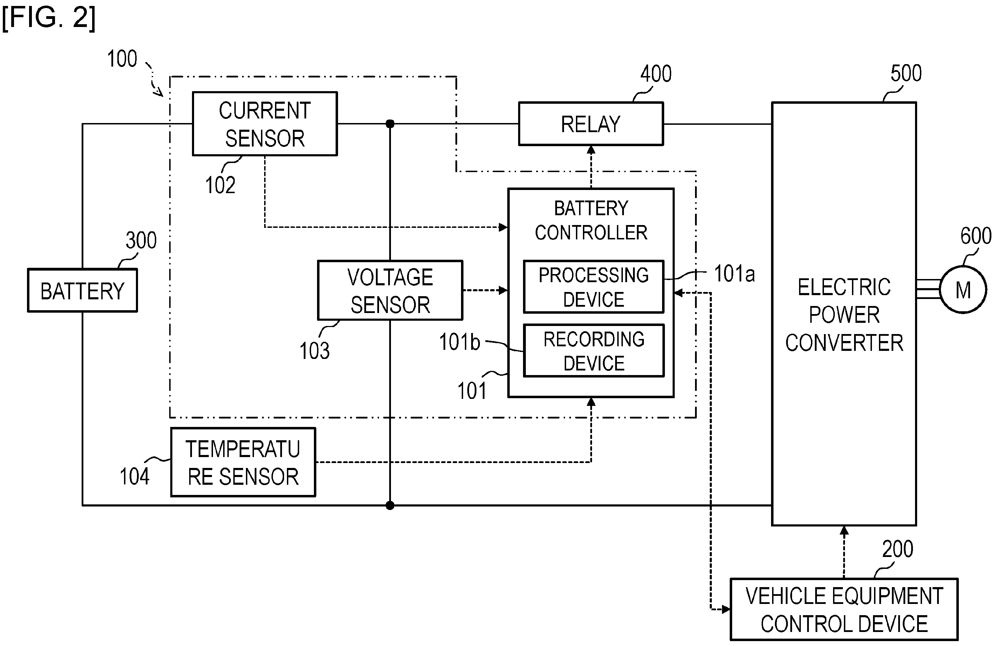

Fig. 2 is a diagram for depicting an example of a hardware configuration of a vehicle control system mounted on the vehicle 1. As depicted in Fig. 2, the battery control device 100 is provided with a battery controller 101, a current sensor 102 connected in series to the battery 300, a voltage sensor 103 connected in parallel to the battery 300, and a temperature sensor 104 provided in the battery 300. The current sensor 102 measures a current I of the battery 300. The voltage sensor 103 measures a voltage V of the battery 300. The temperature sensor 104 measures a temperature T (for example, a surface temperature) of the battery 300. The measurement results of the current sensor 102, the voltage sensor 103, and the temperature sensor 104 are input to the battery controller 101.

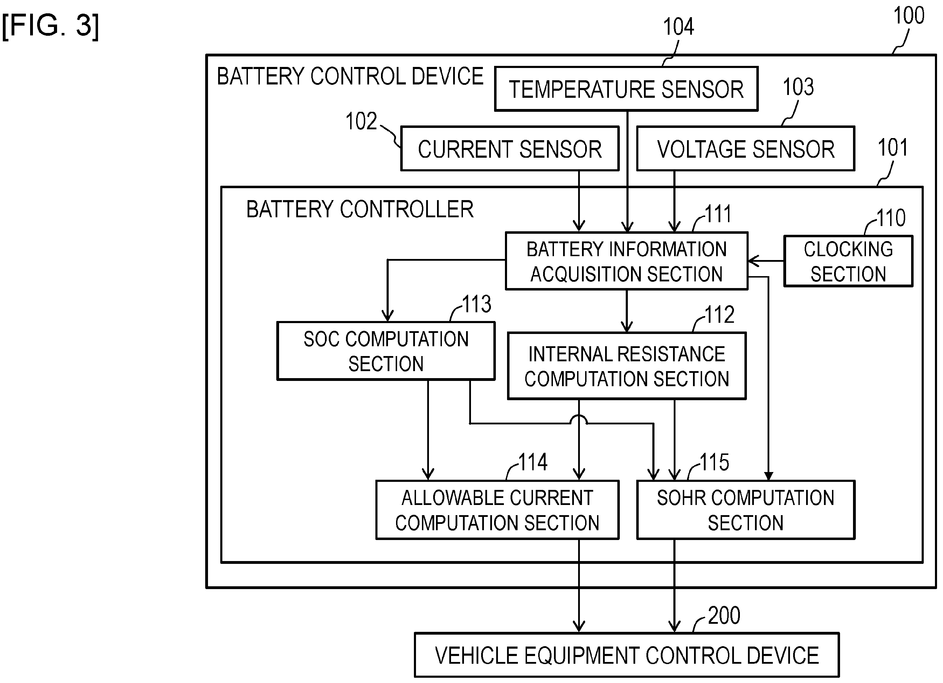

The battery controller 101 is configured with a computer provided with a processing device 101a, a recording device 101b, an input interface, an output interface, and other peripheral circuits. These hardware components work together to operate software and realize a plurality of functions (see Fig. 3 and the like) to be described later. It should be noted that the battery controller 101 may be configured with one computer or a plurality of computers.

The processing device 101a includes, for example, a CPU (Central Processing Unit), an MPU (Micro Processing Unit), a DSP (Digital Signal Processor), and the like. The recording device 101b includes a non-volatile memory such as a ROM (Read Only Memory), a flash memory, and a hard disk drive. In addition, the recording device 101b includes a volatile memory that is generally called a RAM (Random Access Memory).

The non-volatile memory of the recording device 101b stores programs capable of executing various computations. That is, the non-volatile memory is a storage medium (storage device) capable of reading programs for realizing the functions of the present embodiment. The volatile memory is a storage medium (storage device) for temporarily storing a computation result obtained by the processing device 101a and a signal input from the input interface. The processing device 101a is a device that expands the program stored in the non-volatile memory into the volatile memory to execute computation, and performs predetermined computation processing on data taken in from the input interface and the recording device 101b according to the program.

(Functions of battery control device 100)

Fig. 3 is a functional block diagram of the battery control device 100. As depicted in Fig. 3, the battery controller 101 has a clocking section 110, a battery information acquisition section 111, an internal resistance computation section 112, an SOC computation section 113, an allowable current computation section 114, and an SOHR computation section 115.

The clocking section 110 measures time. The battery information acquisition section 111 acquires battery information, which is information related to the state of the battery 300, at predetermined time intervals on the basis of the time measured by the clocking section 110. The battery information includes the measurement results of the current sensor 102, the voltage sensor 103, and the temperature sensor 104.

The internal resistance computation section 112 computes an internal resistance value R of the battery 300 on the basis of the voltage V and the current I of the battery 300 acquired by the battery information acquisition section 111. For example, in a case where the current I changes, the internal resistance computation section 112 calculates the internal resistance value R (DC resistance value DCR) by the following equation (1).

$$R=(V2-V1)/(I2-I1) \quad \ldots \quad (1)$$

Here, a first current I1 is the current value available before the current I changes. A first voltage V1 is the voltage value available before the current I changes. A second current I2 is the current value available after the current I changes. A second voltage V2 is the voltage value available after the current I changes.

The SOC computation section 113 computes a charging rate SOC (State of Charge) of the battery 300. The SOC computation section 113 computes the charging rate SOC by, for example, integrating the current I acquired by the battery information acquisition section 111. It should be noted that the SOC computation section 113 may compute the charging rate SOC from an open voltage OCV available when charging and discharging are not performed.

The allowable current computation section 114 computes an allowable current value on the basis of the internal resistance value R computed by the internal resistance computation section 112 and the charging rate SOC computed by the SOC computation section 113. The computation result of the allowable current computation section 114 is input to the vehicle equipment control device 200.

The SOHR computation section 115 computes a resistance increase rate SOHR of the battery 300 on the basis of the internal resistance value R computed by the internal resistance computation section 112, a reference resistance value Ri, which is an internal resistance value when the product is new, stored in the recording device 101b, and the temperature T, the charging rate SOC, the voltage V, and the current I of the battery 300 acquired by the battery information acquisition section 111. The computation result of the SOHR computation section 115 is input to the vehicle equipment control device 200. The resistance increase rate SOHR is one of the indices indicating the deterioration state of the battery 300. Details of the computation method of the resistance increase rate SOHR will be described later.

The vehicle equipment control device 200 controls each section of the vehicle 1 on the basis of the battery information acquired from the battery control device 100. For example, the vehicle equipment control device 200 controls the electric equipment (the motor 600 and the like) on the basis of the allowable current and the resistance increase rate SOHR acquired from the battery control device 100.

The resistance increase rate SOHR changes according to the charging rate SOC and the temperature T. Therefore, if the resistance increase rate SOHR computed at a temperature near the normal temperature is set as a uniform value in all the SOCs and all the temperature ranges, there is a possibility that errors occur in various kinds of control of the battery 300 and the vehicle 1 using the resistance increase rate SOHR.

Thus, in the present embodiment, data in various deterioration tests is analyzed to create an SOHR map associated with the charging rate SOC and the temperature T of the battery 300, and the SOHR map is fed back to various kinds of control of the battery 300 and the vehicle 1.

(Function of SOHR computation section 115)

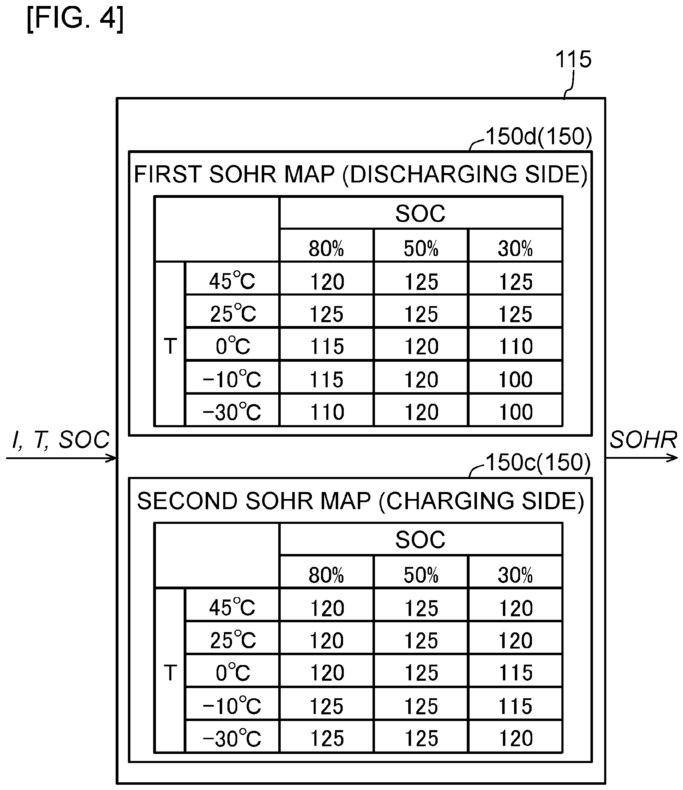

A computation method of the resistance increase rate SOHR using an SOHR map 150 (150d and 150c) will be described with reference to Fig. 4. Fig. 4 is a functional block diagram for depicting a first function of the SOHR computation section 115. As depicted in Fig. 4, to the SOHR computation section 115, the current I and the temperature T of the battery 300 are input from the battery information acquisition section 111 and the charging rate SOC is input from the SOC computation section 113. The SOHR computation section 115 determines whether the battery is being discharged or charged on the basis of the current I. In the case where the battery is being discharged, the SOHR computation section 115 refers to a first SOHR map 150d and computes the resistance increase rate SOHR on the basis of the temperature T measured by the temperature sensor 104 and the charging rate SOC computed by the SOC computation section 113. In the case where the battery is being charged, the SOHR computation section 115 refers to a second SOHR map 150c and computes the resistance increase rate SOHR on the basis of the temperature T measured by the temperature sensor 104 and the charging rate SOC computed by the SOC computation section 113.

The first SOHR map 150d is a map in which a plurality of SOHR recorded values (map values) associated with the temperature T and the charging rate SOC of the battery 300 during discharging are recorded in a table format. The plurality of SOHR recorded values configuring the first SOHR map 150d are values related to values of deterioration accompanied by the discharging of the battery 300. The second SOHR map 150c is a map in which a plurality of SOHR recorded values (map values) associated with the temperature T and the charging rate SOC of the battery 300 during charging are recorded in a table format. The plurality of SOHR recorded values configuring the second SOHR map 150c are values related to values of deterioration accompanied by the charging of the battery 300. The SOHR map 150 (the first SOHR map 150d and the second SOHR map 150c) is created by analyzing the data in various deterioration tests as described above, and is recorded in advance in the recording device 101b. The plurality of SOHR recorded values configuring the SOHR map 150 include different values according to the temperature T and the charging rate SOC.

However, the characteristics of the battery 300 change due to deterioration. Therefore, the SOHR computation section 115 estimates the deterioration of the battery 300 on the basis of at least the resistance increase rate SOHR, and newly generates the SOHR map 150 according to the deterioration estimation result of the battery 300. Specifically, the SOHR computation section 115 computes the plurality of SOHR recorded values on the basis of the deterioration estimation result of the battery 300, and records the plurality of computed SOHR recorded values in the recording device 101b. It should be noted that the new SOHR map 150 may be generated separately from the existing map, or may overwrite the existing map. The SOHR computation section 115 computes the resistance increase rate SOHR of the battery 300 on the basis of at least the temperature T and the charging rate SOC of the battery 300 and the newly generated SOHR map 150.

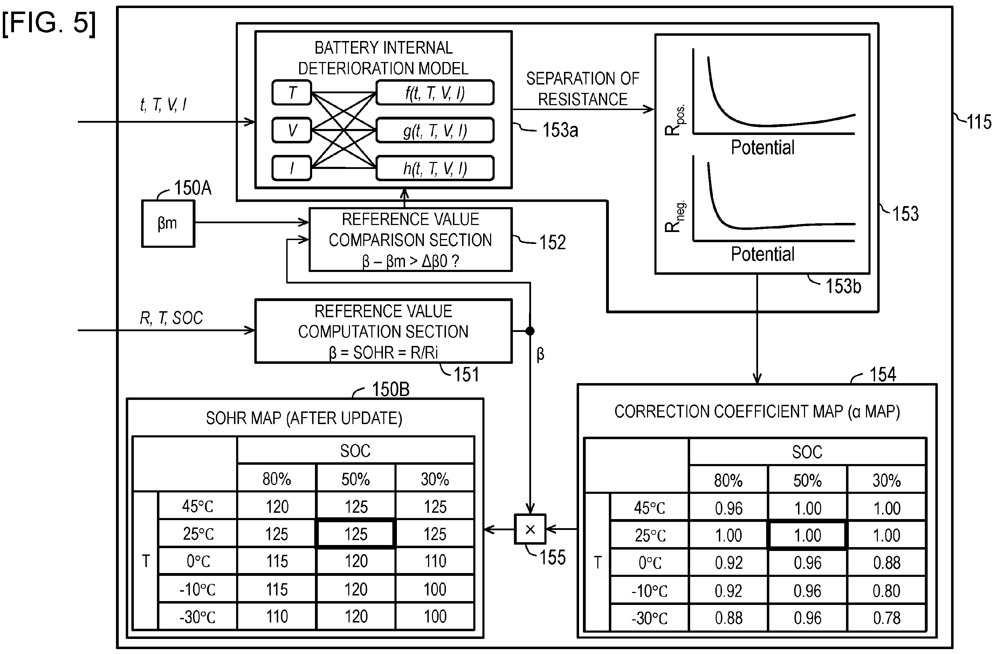

A computation method of the plurality of SOHR recorded values (map values) configuring the SOHR map in the present embodiment will be described with reference to Fig. 5. Fig. 5 is a functional block diagram for depicting a second function of the SOHR computation section 115. The second function is a function of generating a new SOHR map 150. Hereinafter, the second function will be described in detail. It should be noted that, in the following, a case where the first SOHR map 150d is updated (that is, a case where it is overwritten) will be described as an example. As depicted in Fig. 5, the SOHR computation section 115 has a reference value computation section 151, a reference value comparison section 152, a battery deterioration estimation section 153, a correction coefficient map 154, a multiplication section 155, and SOHR maps 150A and 150B. It should be noted that, in the drawing, the SOHR map 150A is the SOHR map 150 available before update, and the SOHR map 150B is the SOHR map 150 available after update.

The reference value computation section 151 computes the resistance increase rate SOHR of the battery 300 on the basis of the internal resistance value R computed by the internal resistance computation section 112 and the reference resistance value Ri stored in the recording device 101b. It should be noted that the internal resistance value R is computed on the basis of the current I measured by the current sensor 102 and the voltage V measured by the voltage sensor 103 as described above. The resistance increase rate SOHR is calculated by dividing the internal resistance value R by the reference resistance value Ri (SOHR = R/Ri).

The reference value computation section 151 computes, as an SOHR reference value β, the resistance increase rate SOHR computed when a predetermined temperature condition and a predetermined SOC condition are satisfied. The predetermined temperature condition is established, for example, in a case where the temperature T of the battery 300 is equal to or higher than 20°C but equal to or lower than 30°C. The predetermined SOC condition is established, for example, in a case where the SOC of the battery 300 is equal to or higher than 40% but equal to or lower than 60%. By setting the temperature condition and the SOC condition in this manner, the error of the computation result can be made small. It should be noted that the above temperature condition and SOC condition are only examples. For example, the temperature condition may be that the temperature T of the battery 300 is equal to or higher than 15°C but equal to or lower than 25°C. In addition, the SOC condition may be different between discharging and charging. The computation accuracy of the internal resistance value R at the time of charging is higher when the charging rate SOC is lower than that at the time of discharging. Hence, for example, the SOC condition at the time of discharging may be that the charging rate SOC of the battery 300 is equal to or higher than 50% but equal to or lower than 80%, and the SOC condition at the time of charging may be that the charging rate SOC of the battery 300 is equal to or higher than 30% but equal to or lower than 60%.

The reference value comparison section 152 compares the SOHR reference value β computed by the reference value computation section 151 with a map reference value βm recorded in the SOHR map 150A. The reference value comparison section 152 uses, as the map reference value βm, the SOHR recorded value available when the temperature T of the battery 300 is 25°C and the charging rate SOC of the battery 300 is 50%.

The SOHR reference value β is the present resistance increase rate SOHR, whereas the map reference value βm is the past resistance increase rate SOHR. The reference value comparison section 152 determines whether or not a change amount Δβ of the resistance increase rate SOHR has exceeded a predetermined change amount threshold value Δβ0. The reference value comparison section 152 calculates a value obtained by subtracting the map reference value βm from the SOHR reference value β, as the change amount Δβ of the resistance increase rate SOHR.

The battery deterioration estimation section 153 acquires the temperature T, the voltage V, and the current I of the battery 300 (hereinafter, referred to as time history data of the battery 300) at each time t from the battery information acquisition section 111. The time history data of the battery 300 is data (load information and operation information) representing use history of the battery 300. The battery deterioration estimation section 153 estimates polarization resistance characteristics 153b of the battery 300 on the basis of a battery internal deterioration model 153a and the time history data of the battery 300. The polarization resistance characteristics 153b include the polarization resistance characteristics of the positive electrode and the polarization resistance characteristics of the negative electrode.

The battery internal deterioration model 153a includes a first function f (t, T, V, I), a second function g (t, T, V, I), and a third function h (t, T, V, I). The first function f (t, T, V, I) is a function for estimating the degree of deterioration of the positive electrode of the battery 300 on the basis of the time history data of the battery 300. The second function g (t, T, V, I) is a function for estimating the degree of deterioration of the negative electrode of the battery 300 on the basis of the time history data of the battery 300. The third function h (t, T, V, I) is a function for estimating an error of the battery capacity caused by the side effect of the battery 300, on the basis of the time history data of the battery 300. These functions f (t, T, V, I), g (t, T, V, I), and h (t, T, V, I) are derived from empirical rules.

The battery deterioration estimation section 153 estimates the resistance characteristics of the battery 300 on the basis of the polarization resistance characteristics 153b of the battery 300, and generates the correction coefficient map 154 on the basis of the estimation result. The correction coefficient map 154 is a map in which a plurality of correction coefficients α associated with the temperature T and the charging rate SOC of the battery 300 are recorded in a table format. In the case where the reference value comparison section 152 determines that the change amount Δβ of the resistance increase rate SOHR has exceeded the change amount threshold value Δβ0, the battery deterioration estimation section 153 estimates the deterioration of the battery 300 by using the battery internal deterioration model 153a, and updates the correction coefficient map 154 on the basis of the deterioration estimation result of the battery 300. As described above, in the present embodiment, the battery deterioration estimation section 153 computes the plurality of correction coefficients α on the basis of the use history including the degree of deterioration of the positive electrode, the degree of deterioration of the negative electrode, and an error of the battery capacity of the battery 300.

In the case where the correction coefficient map 154 is updated by the battery deterioration estimation section 153, the multiplication section 155 updates the SOHR map 150. Specifically, the multiplication section 155 multiplies each of the plurality of correction coefficients α configuring the correction coefficient map 154 by the SOHR reference value β computed by the reference value computation section 151. Accordingly, a plurality of new SOHR recorded values are computed. The computed SOHR recorded values overwrite the existing SOHR recorded value. Accordingly, the updated SOHR map 150B is generated.

It should be noted that the multiplication section 155 sets the SOHR recorded value to 100% in a case where the result obtained by multiplying the correction coefficient α by the SOHR reference value β is less than 100%. In other words, the lower limit value of the SOHR recorded value configuring the SOHR map 150 is set to 100%. Accordingly, it is possible to prevent a control failure caused when the SOHR recorded value becomes less than 100%.

(Effect of first embodiment)

According to the first embodiment, the following working effects are exhibited.

As depicted in Fig. 3, the battery control device 100 has the battery controller 101 as a computation device that computes the resistance increase rate SOHR of the battery (secondary battery) 300. The battery control device 100 has the recording device 101b that records the plurality of SOHR recorded values (see Fig. 4) associated with at least the temperature T and the charging rate SOC of the battery 300. As depicted in Fig. 5, the battery controller 101 estimates the deterioration of the battery 300 on the basis of at least the resistance increase rate SOHR. The battery controller 101 computes the plurality of SOHR recorded values on the basis of the deterioration estimation result of the battery 300. The battery controller 101 records the plurality of computed SOHR recorded values in the recording device 101b. As depicted in Fig. 4, the battery controller 101 computes the resistance increase rate SOHR of the battery 300 on the basis of at least the temperature T and the charging rate SOC of the battery 300 and the plurality of SOHR recorded values recorded in the recording device 101b. According to this configuration, the deterioration estimation result of the battery 300 can be reflected in the control of the battery 300. That is, the battery 300 and the vehicle 1 can appropriately be controlled according to the deterioration of the battery 300. As a result, the battery 300 can maximize the battery performance until, for example, the end of life (EOL) of the battery 300.

As depicted in Fig. 5, the battery controller 101 computes the plurality of correction coefficients $\alpha$ associated with at least the temperature T and the charging rate SOC of the battery 300, on the basis of the deterioration estimation result of the battery 300. The battery controller 101 computes the plurality of SOHR recorded values on the basis of the plurality of computed correction coefficients $\alpha$ and the predetermined SOHR reference value $\beta$. The battery controller 101 records the plurality of computed SOHR recorded values in the recording device 101b. According to this configuration, the SOHR map 150 can appropriately be generated with the predetermined SOHR reference value $\beta$ as a reference.

The battery controller 101 computes the plurality of correction coefficients $\alpha$ on the basis of the use history of the battery 300. Accordingly, in the case where the use frequency of the battery 300 is low, a correction coefficient $\alpha$ corresponding thereto is computed. In addition, in the case where the use frequency of the battery 300 is high, a correction coefficient $\alpha$ corresponding thereto is computed.

The use history includes the degree of deterioration of the positive electrode, the degree of deterioration of the negative electrode, and an error of the battery capacity of the battery 300. According to this configuration, the deterioration of the battery 300 can be estimated accurately as compared with a case where these pieces of information are not taken into consideration. As a result, an appropriate correction coefficient $\alpha$ according to the deterioration state of the battery 300 can be obtained.

The SOHR recorded values configuring the first SOHR map 150d are values related to values of deterioration accompanied by the charging of the battery 300. In addition, the SOHR recorded values configuring the second SOHR map 150c are values related to values of deterioration accompanied by the discharging of the battery 300. According to this configuration, an appropriate resistance increase rate SOHR can be computed according to the charging/discharging state of the battery 300.

The battery control device 100 has the current sensor 102 that measures the current I of the battery 300, the voltage sensor 103 that measures the voltage V of the battery 300, and the temperature sensor 104 that measures the temperature T of the battery 300. The battery controller 101 computes the resistance increase rate SOHR of the battery 300 on the basis of any one or more of the current I measured by the current sensor 102, the voltage V measured by the voltage sensor 103, and the temperature T measured by the temperature sensor 104. According to this configuration, a highly reliable resistance increase rate SOHR can be obtained on the basis of the measurement results of the sensors.

The battery controller 101 computes the charging rate SOC of the battery 300 on the basis of any one or more of the current I measured by the current sensor 102 and the voltage V measured by the voltage sensor 103. The battery controller 101 computes the resistance increase rate SOHR on the basis of the computed charging rate SOC, the temperature T measured by the temperature sensor 104, and the plurality of SOHR recorded values. According to this configuration, an appropriate resistance increase rate SOHR corresponding to the charging rate SOC and the temperature T can be obtained using the plurality of SOHR recorded values.

The battery controller 101 computes the resistance increase rate SOHR of the battery 300 on the basis of at least the current I measured by the current sensor 102 and the voltage V measured by the voltage sensor 103. The battery controller 101 sets, as the SOHR reference value $\beta$, the resistance increase rate SOHR computed when a predetermined temperature condition and a predetermined SOC condition are satisfied. According to this configuration, a highly accurate resistance increase rate SOHR can be set as the SOHR reference value $\beta$. As a result, a highly accurate SOHR map 150 can be generated.

The battery controller 101 computes the plurality of SOHR recorded values on the basis of the plurality of correction coefficients $\alpha$ and the SOHR reference value $\beta$ in the case where the change amount $\Delta\beta$ of the SOHR reference value exceeds the predetermined change amount threshold value $\Delta\beta0$. The battery controller 101 records the plurality of computed SOHR recorded values in the recording device 101b. According to this configuration, in the case where the change amount $\Delta\beta$ of the SOHR reference value does not exceed the predetermined change amount threshold value $\Delta\beta0$, a new SOHR recorded value is not computed. Accordingly, the computation load of the battery controller 101 is reduced.

The vehicle control device 10 is provided with the battery control device 100 having the above features. The vehicle control device 10 controls the vehicle 1 having the battery 300 and the electric equipment (the motor 600 and the like) operated by the electric power of the battery 300. According to this configuration, since the reliability of the resistance increase rate SOHR used for computation by the vehicle control device 10 is improved, the vehicle control device 10 can more appropriately control the electric equipment (the motor 600 and the like).

As depicted in Fig. 1, the vehicle 1 has the internal combustion engine (engine 700) that drives the vehicle 1 to travel. Since the reliability of the resistance increase rate SOHR used for various kinds of computation in the vehicle control device 10 is improved, the vehicle control device 10 can more appropriately control the motor 600 and the engine 700 when the vehicle is travelling.

[Second Embodiment]

(Function of SOHR computation section 215 of second embodiment)

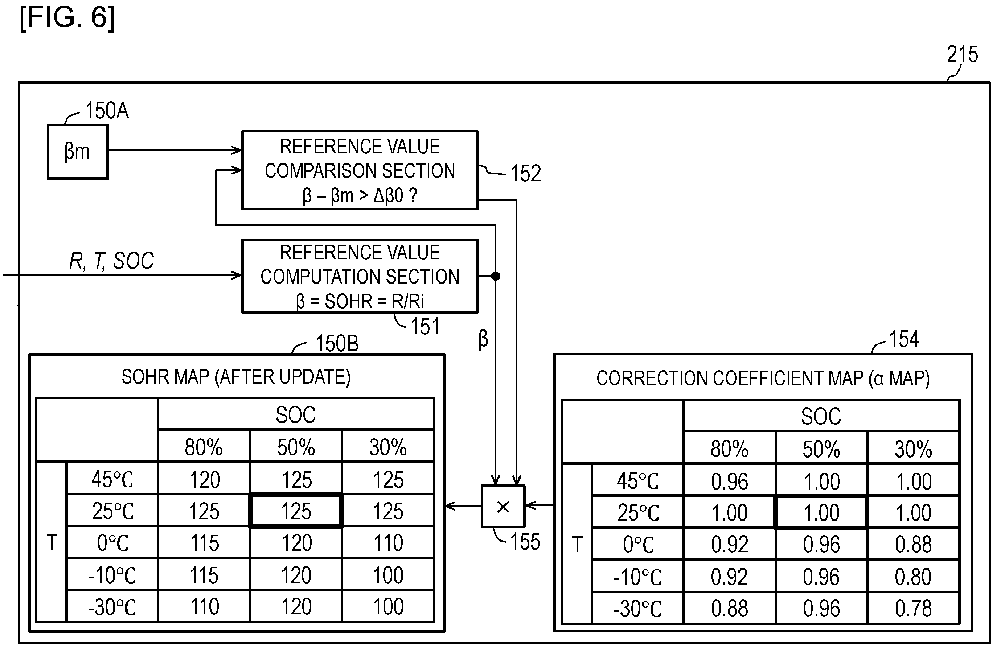

A second function of an SOHR computation section 215 of a battery control device according to a second embodiment will be described with reference to Fig. 6. It should be noted that, since a first function of the SOHR computation section 215 is the same as the first function of the SOHR computation section 115, the description thereof will be omitted. Fig. 6 is a functional block diagram for depicting the second function of the SOHR computation section 215 of the second embodiment. Configurations of the SOHR computation section 215 same as those of the SOHR computation section 115 are denoted by reference characters same as those of the SOHR computation section 115, and the description thereof is omitted. Configurations of the SOHR computation section 215 different from those of the SOHR computation section 115 are described by being denoted by reference characters different from those of the SOHR computation section 115.

In the first embodiment, an example in which the SOHR computation section 115 estimates the deterioration of the battery 300 on the basis of the battery internal deterioration model 153a and generates the SOHR map 150 on the basis of the estimation result has been described. In contrast, the SOHR computation section 215 according to the second embodiment generates the SOHR map 150 without using the battery internal deterioration model 153a. That is, in the second embodiment, the correction coefficient map 154 is not updated by the battery deterioration estimation section 153. The correction coefficient map 154 is an initial map recorded in advance in the recording device 101b.

In the second embodiment, the multiplication section 155 updates the SOHR map 150 in a case where the reference value comparison section 152 determines that the change amount $\Delta\beta$ of the resistance increase rate SOHR has exceeded the change amount threshold value $\Delta\beta0$. Specifically, the multiplication section 155 multiplies each of the plurality of correction coefficients $\alpha$ configuring the correction coefficient map 154 by the SOHR reference value $\beta$ computed by the reference value computation section 151. Accordingly, a plurality of new SOHR recorded values is computed. The computed SOHR recorded values overwrite the existing SOHR recorded values. Accordingly, the updated SOHR map 150B is generated.

(Effect of second embodiment)

The battery controller 101 of the second embodiment computes the resistance increase rate SOHR of the battery 300 on the basis of the current I measured by the current sensor 102 and the voltage V measured by the voltage sensor 103. The battery controller 101 sets, as the SOHR reference value $\beta$, the resistance increase rate SOHR computed when a predetermined temperature condition and a predetermined SOC condition are satisfied. The battery controller 101 computes the plurality of SOHR recorded values on the basis of the plurality of correction coefficients $\alpha$ and the SOHR reference value $\beta$ in the case where the change amount $\Delta\beta$ of the SOHR reference value exceeds the predetermined change amount threshold value $\Delta\beta0$. The battery controller 101 records the plurality of computed SOHR recorded values in the recording device 101b. According to this configuration, a change in the resistance increase rate SOHR obtained as the deterioration estimation result of the battery 300 can be reflected in the control of the battery 300. As a result, the battery 300 can maximize the battery performance until, for example, the end of life (EOL) of the battery 300. In addition, according to this configuration, in the case where the change amount $\Delta\beta$ of the SOHR reference value does not exceed the predetermined change amount threshold value $\Delta\beta0$, a new SOHR recorded value is not computed. Accordingly, the computation load of the battery controller 101 is reduced.

It should be noted that, in the second embodiment, the correction coefficient map may be input to the battery controller 101 through an input device, a communication device, a storage medium, or the like, and recorded in the recording device 101b.

[Third Embodiment]

(Function of SOHR computation section 315 of third embodiment)

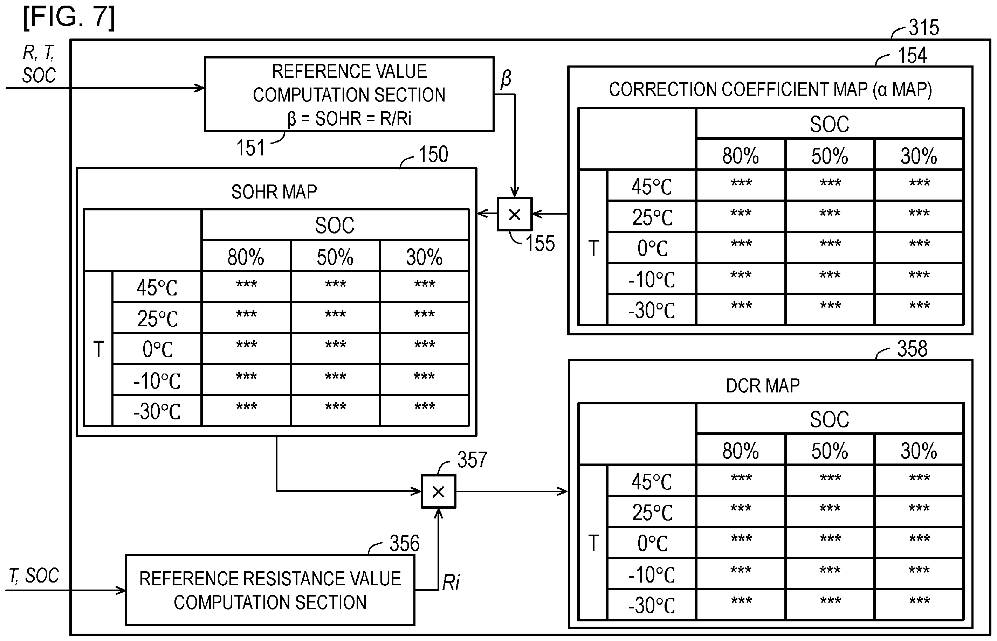

A second function of an SOHR computation section 315 of a battery control device according to a third embodiment will be described with reference to Fig. 7. It should be noted that, since a first function of the SOHR computation section 315 is the same as the first function of the SOHR computation section 115, the description thereof will be omitted. Fig. 7 is a functional block diagram for depicting the second function of the SOHR computation section 315 of the third embodiment. Configurations of the SOHR computation section 315 same as those of the SOHR computation section 115 are denoted by reference characters same as those of the SOHR computation section 115, and the description thereof is omitted. Configurations of the SOHR computation section 315 different from those of the SOHR computation section 115 are described by being denoted by reference characters different from those of the SOHR computation section 115. It should be noted that, although not illustrated, the SOHR computation section 315 has the reference value comparison section 152 and the battery deterioration estimation section 153.

The SOHR computation section 315 of the third embodiment has the reference value computation section 151, the reference value comparison section 152 (not illustrated), the battery deterioration estimation section 153 (not illustrated), the correction coefficient map 154, the multiplication section 155, and the SOHR map 150. The SOHR computation section 315 further has a reference resistance value computation section 356, a multiplication section 357, and a DCR map 358.

The DCR map 358 is a map in which a plurality of DCR recorded values (map values) associated with the temperature T and the charging rate SOC of the battery 300 are recorded in a table format.

The reference resistance value computation section 356 computes the reference resistance value Ri on the basis of the charging rate SOC of the battery 300 computed by the SOC computation section 113, the temperature T of the battery 300 measured by the temperature sensor 104, and a temperature-resistance correlation map. The temperature-resistance correlation map is a data table that defines the correlation between the temperature T of the battery 300 and the reference resistance value Ri. The temperature-resistance correlation map is set in advance by an experiment or the like and recorded in the recording device 101b. A plurality of temperature-resistance correlation maps associated with the charging rate SOC are recorded in the recording device 101b.

In a case where a new SOHR map 150 is generated, the multiplication section 357 multiplies each of a plurality of SOHR recorded values configuring the new SOHR map 150 by the reference resistance value Ri computed by the reference resistance value computation section 356. Accordingly, a plurality of new DCR recorded values are computed. The plurality of computed DCR recorded values overwrite the existing DCR recorded values. Accordingly, the updated DCR map 358 is generated.

That is, in the case where the SOHR map 150 is updated, the multiplication section 357 updates the DCR map 358. It should be noted that the DCR map 358 is not limited to the case where it overwrites the existing map. The new DCR map 358 may be generated separately from the existing map.

Although not illustrated, the internal resistance computation section 112 according to the third embodiment refers to the DCR map 358 and computes the internal resistance value R (DC resistance value DCR) on the basis of the temperature T measured by the temperature sensor 104 and the charging rate SOC computed by the SOC computation section 113. The internal resistance value R thus computed is used for computing and controlling various parameters (the charging rate SOC, the resistance increase rate SOHR, and the like) of the battery 300.

(Effect of third embodiment)

The plurality of DCR recorded values associated with at least the temperature T and the charging rate SOC of the battery 300 is recorded in the recording device 101b of the battery controller 101 of the third embodiment. The battery controller 101 computes the plurality of DCR recorded values on the basis of the plurality of SOHR recorded values recorded in the recording device 101b. The battery controller 101 records the plurality of computed DCR recorded values in the recording device 101b. The battery controller 101 computes the internal resistance value R (DC resistance value DCR) of the battery 300 on the basis of at least the temperature T and the charging rate SOC of the battery 300 and the plurality of DCR recorded values recorded in the recording device 101b. According to this configuration, a highly reliable internal resistance value R (DC resistance value DCR) according to the temperature T and the charging rate SOC can be obtained in addition to the working effects similar to those of the first embodiment. The internal resistance value R is used for various kinds of control of the battery 300 and the vehicle 1.

[Fourth Embodiment]

(Function of SOHR computation section 415 of fourth embodiment)

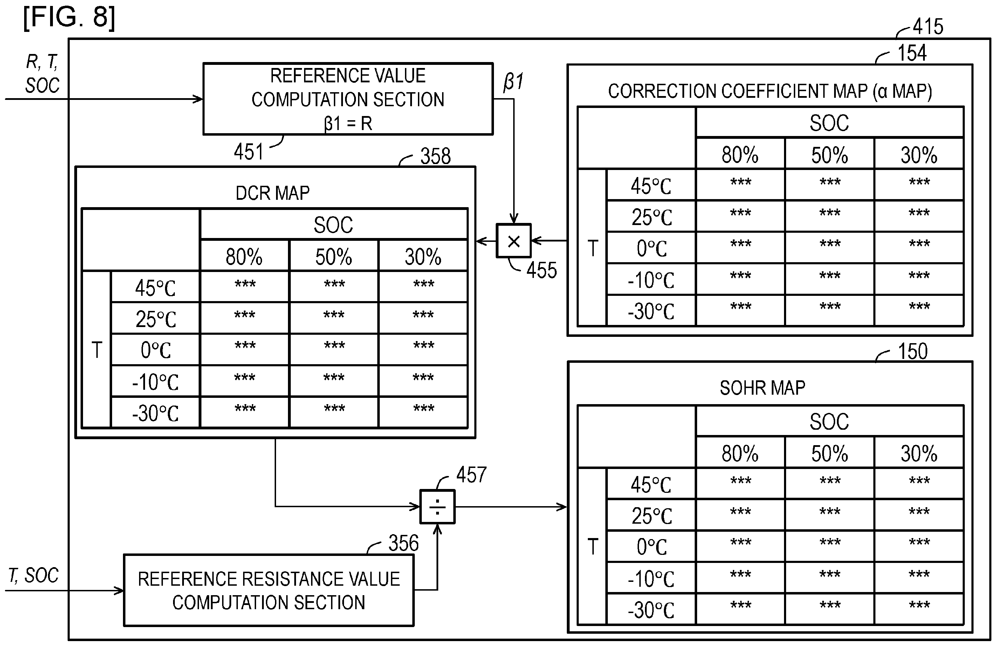

A second function of an SOHR computation section 415 of a battery control device according to a fourth embodiment will be described with reference to Fig. 8. It should be noted that, since a first function of the SOHR computation section 415 is the same as the first function of the SOHR computation section 115, the description thereof will be omitted. Fig. 8 is a functional block diagram for depicting the second function of the SOHR computation section 415 of the fourth embodiment. Configurations of the SOHR computation section 415 same as those of the SOHR computation sections 115 and 315 are denoted by reference characters same as those of the SOHR computation sections 115 and 315, and the description thereof is omitted. Configurations of the SOHR computation section 415 different from those of the SOHR computation sections 115 and 315 are described by being denoted by reference characters different from those of the SOHR computation sections 115 and 315. It should be noted that, although not illustrated, the SOHR computation section 415 has the reference value comparison section 152 and the battery deterioration estimation section 153.

The SOHR computation section 415 of the fourth embodiment has the reference value comparison section 152 (not illustrated), the battery deterioration estimation section 153 (not illustrated), the correction coefficient map 154, the SOHR map 150, the reference resistance value computation section 356, and the DCR map 358. It should be noted that the SOHR computation section 415 according to the fourth embodiment has a reference value computation section 451 and a multiplication section 455 instead of the reference value computation section 151 and the multiplication section 155 of the third embodiment. In addition, the SOHR computation section 415 of the fourth embodiment has a division section 457 instead of the multiplication section 357 of the third embodiment.

The reference value computation section 451 has the following functions in addition to the functions of the reference value computation section 151. The reference value computation section 451 computes, as a resistance reference value $\beta1$, the internal resistance value R computed when a predetermined temperature condition and a predetermined SOC condition are satisfied. The predetermined temperature condition is established, for example, in a case where the temperature T of the battery 300 is equal to or higher than 20°C but equal to or lower than 30°C. The predetermined SOC condition is established, for example, in a case where the charging rate SOC of the battery 300 is equal to or higher than 40% but equal to or lower than 60%.

The multiplication section 455 updates the DCR map 358 in a case where the correction coefficient map 154 is updated. Specifically, the multiplication section 455 multiplies each of the plurality of correction coefficients $\alpha$ configuring the correction coefficient map 154 by the resistance reference value $\beta1$ computed by the reference value computation section 451. Accordingly, a plurality of new DCR recorded values are computed. The computed DCR recorded values overwrite the existing DCR recorded values. Accordingly, the updated DCR map 358 is generated.

The division section 457 updates the SOHR map 150 in the case where the DCR map 358 is updated. Specifically, the division section 457 divides each of the plurality of DCR recorded values configuring the DCR map 358 by the reference resistance value Ri computed by the reference resistance value computation section 356. Accordingly, a plurality of new SOHR recorded values are computed. The plurality of computed SOHR recorded values overwrite the existing SOHR recorded values. Accordingly, the updated SOHR map 150 is generated.

It should be noted that the DCR map 358 and the SOHR map 150 are not limited to the case where they overwrite the existing maps. The new DCR map 358 and the SOHR map 150 may be generated separately from the existing maps.

(Effect of fourth embodiment)

The plurality of DCR recorded values associated with at least the temperature T and the charging rate SOC of the battery 300 is recorded in the recording device 101b of the battery controller 101 of the fourth embodiment. The battery controller 101 computes the plurality of correction coefficients $\alpha$ associated with at least the temperature T and the charging rate SOC of the battery 300, on the basis of the deterioration estimation result of the battery 300. The battery controller 101 computes the plurality of DCR recorded values on the basis of the plurality of correction coefficients $\alpha$ and the predetermined DCR reference value. The battery controller 101 records the plurality of computed DCR recorded values in the recording device 101b. The battery controller 101 computes the plurality of SOHR recorded values on the basis of the plurality of DCR recorded values recorded in the recording device 101b. According to this configuration, the working effects similar to those of the third embodiment can be obtained.

[Fifth Embodiment]

(Function of SOHR computation section 515 of fifth embodiment)

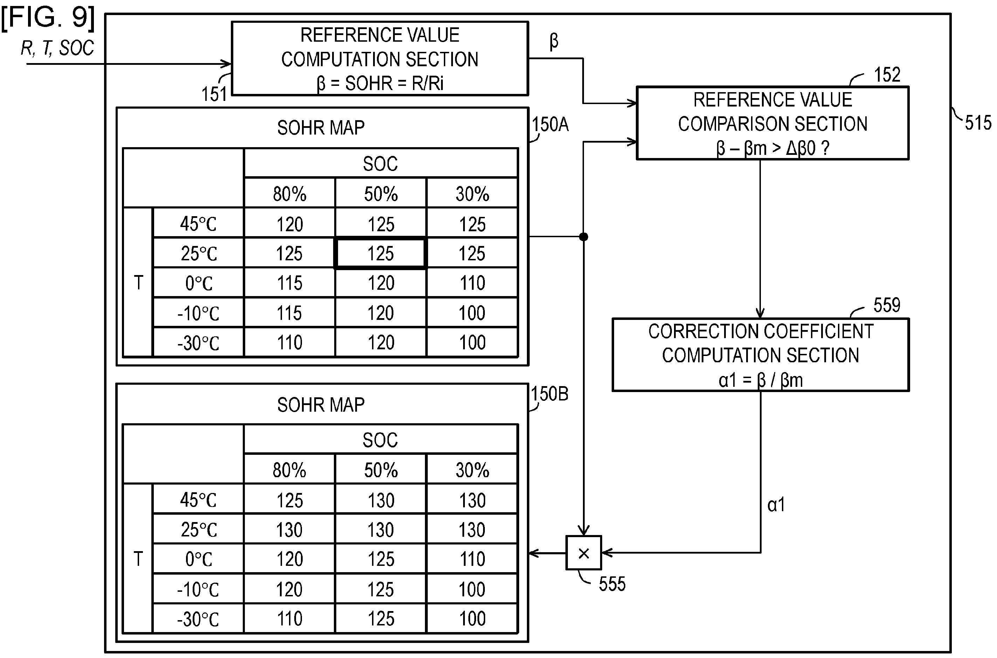

A second function of an SOHR computation section 515 of a battery control device according to a fifth embodiment will be described with reference to Fig. 9. It should be noted that, since a first function of the SOHR computation section 515 is the same as the first function of the SOHR computation section 115, the description thereof will be omitted. Fig. 9 is a functional block diagram for depicting the second function of the SOHR computation section 515 of the fifth embodiment. Configurations of the SOHR computation section 515 same as those of the SOHR computation section 115 are denoted by reference characters same as those of the SOHR computation section 115, and the description thereof is omitted. Configurations of the SOHR computation section 515 different from those of the SOHR computation section 115 are described by being denoted by reference characters different from those of the SOHR computation section 115.

In the first embodiment, an example in which the SOHR computation section 115 generates the SOHR map 150 by using the correction coefficient map 154 (see Fig. 5) including the plurality of correction coefficients $\alpha$ has been described. In contrast, the SOHR computation section 515 of the fifth embodiment computes a single correction coefficient $\alpha$ on the basis of a change in the resistance increase rate SOHR representing the deterioration estimation result of the battery 300, and generates the SOHR map 150 by using the computation result.

The SOHR computation section 515 of the fifth embodiment has the reference value computation section 151, the reference value comparison section 152, a multiplication section 555, a correction coefficient computation section 559, and SOHR maps 150A and 150B.

In the case where the reference value comparison section 152 determines that the change amount $\Delta\beta$ of the resistance increase rate SOHR has exceeded the change amount threshold value $\Delta\beta0$, the correction coefficient computation section 559 computes a single correction coefficient $\alpha1$ by dividing the SOHR reference value $\beta$ by the map reference value $\beta m$. The correction coefficient $\alpha1$ is a ratio between the map reference value $\beta m$ and the SOHR reference value $\beta$, and can be said to be a parameter representing the deterioration estimation result of the battery 300. For example, in a case where the SOHR reference value $\beta$ is 130% and the map reference value $\beta m$ is 125%, the correction coefficient $\alpha1$ is 1.04. The multiplication section 555 multiplies each of the plurality of SOHR recorded values configuring the SOHR map 150A by the correction coefficient $\alpha1$ computed by the correction coefficient computation section 559. Accordingly, a plurality of new SOHR recorded values are computed. The computed SOHR recorded values overwrite the existing SOHR recorded values. Accordingly, the updated SOHR map 150B is generated.

As described above, in the fifth embodiment, in a case where the resistance increase rate SOHR is actually measured and compared with the map value at the temperature T and the charging rate SOC at that time and the difference is large, all the SOHR recorded values configuring the SOHR map 150 are updated. It should be noted that the SOHR map 150 is not limited to a case of overwriting the existing map. The new SOHR map 150 may be generated separately from the existing map.

(Effect of fifth embodiment)

The battery controller 101 computes a ratio between a predetermined SOHR recorded value (map reference value $\beta m$) included in the plurality of SOHR recorded values and the computed resistance increase rate SOHR (SOHR reference value $\beta$), as the deterioration estimation result of the battery 300. The battery controller 101 computes a plurality of new SOHR recorded values on the basis of the computed ratio (correction coefficient $\alpha1$) and the plurality of SOHR recorded values. The battery controller 101 records the plurality of computed new SOHR recorded values in the recording device 101b. The battery controller 101 computes the resistance increase rate SOHR of the battery 300 on the basis of at least the temperature T and the charging rate SOC of the battery 300 and the plurality of new SOHR recorded values recorded in the recording device 101b. According to this configuration, in a case where the resistance increase rate SOHR, which is an index indicating the deterioration state of the battery 300, changes, the plurality of new SOHR recorded values can be recorded according to the change. As a result, appropriate control according to the deterioration state of the battery 300 can be executed.

The following modified examples are also within the scope of the present invention, and it is possible to combine configurations to be depicted in the modified examples with the configurations described in the above embodiments, or to combine configurations to be described in the following different modified examples with each other.

(Modified example 1)

An example in which the battery internal deterioration model 153a includes the first function f (t, T, V, I) for estimating the degree of deterioration of the positive electrode of the battery 300, the second function g (t, T, V, I) for estimating the degree of deterioration of the negative electrode of the battery 300, and the third function h (t, T, V, I) for estimating an error of the battery capacity has been described. However, the present invention is not limited thereto. It is preferable that the battery internal deterioration model 153a include any one or more of the functions f (t, T, V, I), g (t, T, V, I), and h (t, T, V, I). By using any one or more of the functions f (t, T, V, I), g (t, T, V, I), and h (t, T, V, I) and the time history data of the battery 300, the deterioration estimation result of the battery 300 is obtained in consideration of the use history including one or more of the degree of deterioration of the positive electrode of the battery 300, the degree of deterioration of the negative electrode, and an error of the battery capacity.

(Modified example 2)

The battery controller 101 may compute the SOHR reference value $\beta$ on the basis of the use history of the battery 300. In this case, it is preferable that the use history include any one or more of the degree of deterioration of the positive electrode of the battery 300, the degree of deterioration of the negative electrode, and an error of the battery capacity. For example, in the first embodiment depicted in Fig. 5, the battery deterioration estimation section 153 may correct (change) the SOHR reference value $\beta$ on the basis of the time history data of the battery 300 and the deterioration estimation result of the battery 300 using the battery internal deterioration model 153a. In this case, the multiplication section 155 multiplies each of the plurality of correction coefficients $\alpha$ configuring the correction coefficient map 154 by the corrected SOHR reference value $\beta$. Accordingly, a plurality of new SOHR recorded values are computed. According to this configuration, the accuracy of the plurality of SOHR recorded values can be further improved. In addition, in the second through fourth embodiments, the battery controller 101 may correct (change) the SOHR reference value $\beta$ on the basis of the use history of the battery 300.

(Modified example 3)

In the above embodiments, an example in which the SOHR map 150 recorded in the recording device 101b includes the first SOHR map 150d used during charging and the second SOHR map 150c used during discharging has been described. However, the present invention is not limited thereto. Only one of the first SOHR map 150d and the second SOHR map 150c may be recorded in the recording device 101b. That is, each of the SOHR recorded values configuring the SOHR map 150 may be a value related to any one or more of a value of deterioration accompanied by the charging of the battery 300 and a value of deterioration accompanied by the discharging of the battery 300.

Although the embodiments of the present invention have been described above, the above embodiments merely depict some examples of application of the present invention, and are not intended to limit the technical scope of the present invention to the specific configurations of the above embodiments. For example, the present invention is not limited to the case where it is applied to the battery control device 100 that controls the battery 300 mounted on the vehicle 1 as depicted in Fig. 1. The present invention can be applied to the battery control device 100 that controls the battery 300 as a power source for operating various industrial machines such as airplanes and machine tools.

Description of Reference Characters

    1: Vehicle
    10: Vehicle control device
    20: Battery pack
    100: Battery control device
    101: Battery controller (computation device)
    101a: Processing device
    101b: Recording device
    102: Current sensor
    103: Voltage sensor
    104: Temperature sensor
    110: Clocking section
    111: Battery information acquisition section
    112: Internal resistance computation section
    113: SOC computation section
    114: Allowable current computation section
    115: SOHR computation section
    150: SOHR map
    150A: SOHR map (before update)
    150B: SOHR map (after update)
    150c: Second SOHR map
    150d: First SOHR map
    151: Reference value computation section
    152: Reference value comparison section
    153: Battery deterioration estimation section
    153a: Battery internal deterioration model

    153b: Polarization resistance characteristic
    154: Correction coefficient map
    155: Multiplication section
    200: Vehicle equipment control device
    215: SOHR computation section
    300: Battery (secondary battery)
    315: SOHR computation section
    356: Reference resistance value computation section
    357: Multiplication section
    358: DCR map
    400: Relay
    415: SOHR computation section
    451: Reference value computation section
    455: Multiplication section
    457: Division section
    500: Electric power converter
    515: SOHR computation section
    555: Multiplication section
    559: Correction coefficient computation section
    600: Motor (electric equipment)
    700: Engine (internal combustion engine)
    DCR: DC resistance value
    f: First function
    g: Second function
    h: Third function
    I: Current
    I1: First current
    I2: Second current
    OCV: Open voltage
    R: Internal resistance value
    Ri: Reference resistance value
    SOC: Charging rate
    SOHR: Resistance increase rate
    t: Time
    T: Temperature
    V: Voltage
    V1: First voltage
    V2: Second voltage
    $\alpha$: Correction coefficient
    $\alpha$1: Correction coefficient
    $\beta$: SOHR reference value
    $\beta$1: Resistance reference value
    $\beta$m: Map reference value
    $\Delta\beta$: Change amount in resistance increase rate
    $\Delta\beta$0: Change amount threshold value

**Claims**

1. A battery control device comprising:

    a computation device that computes an SOHR of a secondary battery; and
    a recording device that records a plurality of SOHR recorded values associated with at least a temperature and an SOC of the secondary battery,

wherein the computation device

estimates deterioration of the secondary battery on a basis of at least the SOHR, computes the plurality of SOHR recorded values on a basis of a deterioration estimation result of the secondary battery, records the plurality of computed SOHR recorded values in the recording device, and computes the SOHR of the secondary battery on a basis of at least the temperature and the SOC of the secondary battery and the plurality of SOHR recorded values recorded in the recording device.

2. The battery control device according to claim 1, wherein the computation device

computes a plurality of correction coefficients associated with at least the temperature and the SOC of the secondary battery on the basis of the deterioration estimation result of the secondary battery, computes the plurality of SOHR recorded values on a basis of the plurality of computed correction coefficients and a predetermined SOHR reference value, and records the plurality of computed SOHR recorded values in the recording device.

3. The battery control device according to claim 2, wherein the computation device computes the plurality of correction coefficients on a basis of use history of the secondary battery.

4. The battery control device according to claim 3, wherein the use history includes any one or more of a degree of deterioration of a positive electrode, a degree of deterioration of a negative electrode, and an error of a battery capacity of the secondary battery.

5. The battery control device according to claim 2, wherein the computation device computes the SOHR reference value on a basis of use history of the secondary battery.

6. The battery control device according to claim 5, wherein the use history includes any one or more of a degree of deterioration of a positive electrode, a degree of deterioration of a negative electrode, and an error of a battery capacity of the secondary battery.

7. The battery control device according to claim 1, wherein a plurality of DCR recorded values associated with at least the temperature and the SOC of the secondary battery are recorded in the recording device, and the computation device

computes the plurality of DCR recorded values on a basis of the plurality of SOHR recorded values recorded in the recording device, records the plurality of computed DCR recorded values in the recording device, and computes a DCR of the secondary battery on a basis of at least the temperature and the SOC of the secondary battery and the plurality of DCR recorded values recorded in the recording device.

8. The battery control device according to claim 1,

wherein a plurality of DCR recorded values associated with at least the temperature and the SOC of the secondary battery are recorded in the recording device, and the computation device

computes a plurality of correction coefficients associated with at least the temperature and the SOC of the secondary battery, on the basis of the deterioration estimation result of the secondary battery, computes the plurality of DCR recorded values on a basis of the plurality of correction coefficients and a predetermined DCR reference value, records the plurality of computed DCR recorded values in the recording device, and computes the plurality of SOHR recorded values on a basis of at least the temperature and the SOC of the secondary battery and the plurality of DCR recorded values recorded in the recording device.

9. The battery control device according to claim 1, wherein the computation device

computes a ratio between a predetermined SOHR recorded value included in the plurality of SOHR recorded values and the computed SOHR, as the deterioration estimation result of the secondary battery, computes a plurality of new SOHR recorded values on a basis of the computed ratio and the plurality of SOHR recorded values, records the plurality of computed new SOHR recorded values in the recording device, and computes the SOHR of the secondary battery on a basis of the plurality of new SOHR recorded values recorded in the recording device.

10. The battery control device according to claim 1, wherein each of the SOHR recorded values is a value related to any one or more of a value of deterioration accompanied by charging of the secondary battery and a value of deterioration accompanied by discharging of the secondary battery.

11. The battery control device according to claim 1, further comprising:

   a current sensor that measures a current of the secondary battery;
   a voltage sensor that measures a voltage of the secondary battery; and
   a temperature sensor that measures the temperature of the secondary battery,
   wherein the computation device computes the SOHR of the secondary battery on a basis of any one or more of the current measured by the current sensor, the voltage measured by the voltage sensor, and the temperature measured by the temperature sensor.

12. The battery control device according to claim 2, wherein the computation device

   computes the SOHR of the secondary battery on a basis of at least a current measured by a current sensor and a voltage measured by a voltage sensor, and
   sets the SOHR computed when a predetermined temperature condition and a predetermined SOC condition are satisfied as the SOHR reference value.

13. The battery control device according to claim 12, wherein the computation device

   computes the plurality of SOHR recorded values on the basis of the plurality of correction coefficients and the SOHR reference value in a case where a change amount of the SOHR reference value exceeds a predetermined change amount threshold value, and
   records the plurality of computed SOHR recorded values in the recording device.

14. A vehicle control device comprising:

   the battery control device according to claim 1, wherein a vehicle having the secondary battery and electric equipment operated by electric power of the secondary battery is controlled.

15. The vehicle control device according to claim 14, wherein the vehicle has an internal combustion engine that drives the vehicle to travel.

[FIG. 1]

VEHICLE CONTROL DEVICE

BATTERY PACK

BATTERY CONTROL DEVICE

VEHICLE EQUIPMENT CONTROL DEVICE

BATTERY

RELAY

ELECTRIC POWER CONVERTER (DC⇔AC)

MOTOR

ENGINE

[FIG. 2]

EP 4 786 997 A1

[FIG. 3]

[FIG. 4]

115

150d(150)

**FIRST SOHR MAP (DISCHARGING SIDE)**

| | | SOC | | |
|---|---|---|---|---|
| | | 80% | 50% | 30% |
| | 45°C | 120 | 125 | 125 |
| | 25°C | 125 | 125 | 125 |
| T | 0°C | 115 | 120 | 110 |
| | −10°C | 115 | 120 | 100 |
| | −30°C | 110 | 120 | 100 |

*I, T, SOC* →

SOHR →

150c(150)

**SECOND SOHR MAP (CHARGING SIDE)**

| | | SOC | | |
|---|---|---|---|---|
| | | 80% | 50% | 30% |
| | 45°C | 120 | 125 | 120 |
| | 25°C | 120 | 125 | 120 |
| T | 0°C | 120 | 125 | 115 |
| | −10°C | 125 | 125 | 115 |
| | −30°C | 125 | 125 | 120 |

[FIG. 5]

**CORRECTION COEFFICIENT MAP (α MAP)** (154)

| T | 80% | SOC 50% | 30% |
|---|---|---|---|---|
| | | 80% | 50% | 30% |
| 45°C | 0.96 | 1.00 | 1.00 |
| 25°C | 1.00 | 1.00 | 1.00 |
| 0°C | 0.92 | 0.96 | 0.88 |
| -10°C | 0.92 | 0.96 | 0.80 |
| -30°C | 0.88 | 0.96 | 0.78 |

**SOHR MAP (AFTER UPDATE)** (150B)

| T | 80% | SOC 50% | 30% |
|---|---|---|---|
| | 80% | 50% | 30% |
| 45°C | 120 | 125 | 125 |
| 25°C | 125 | 125 | 125 |
| 0°C | 115 | 120 | 110 |
| -10°C | 115 | 120 | 100 |
| -30°C | 110 | 120 | 100 |

BATTERY INTERNAL DETERIORATION MODEL

$f(t, T, V, I)$
$g(t, T, V, I)$
$h(t, T, V, I)$

$T$  $V$  $I$

REFERENCE VALUE COMPARISON SECTION (152)
β − βm > Δβ0 ?

REFERENCE VALUE COMPUTATION SECTION (151)
β = SOHR = R/Ri

SEPARATION OF RESISTANCE (153)

$R_{pos.}$  Potential
$R_{neg.}$  Potential
(153a, 153b)

β (155) ×

βm (150A)

$t, T, V, I$

$R, T, SOC$

(115)

[FIG. 6]

| SOHR MAP (AFTER UPDATE) | | | |
|---|---|---|---|
| | SOC | | |
| | 80% | 50% | 30% |
| 45°C | 120 | 125 | 125 |
| 25°C | 125 | 125 | 125 |
| T 0°C | 115 | 120 | 110 |
| -10°C | 115 | 120 | 100 |
| -30°C | 110 | 120 | 100 |

| CORRECTION COEFFICIENT MAP (α MAP) | | | |
|---|---|---|---|
| | SOC | | |
| | 80% | 50% | 30% |
| 45°C | 0.96 | 1.00 | 1.00 |
| 25°C | 1.00 | 1.00 | 1.00 |
| T 0°C | 0.92 | 0.96 | 0.88 |
| -10°C | 0.92 | 0.96 | 0.80 |
| -30°C | 0.88 | 0.96 | 0.78 |

EP 4 786 997 A1

## [FIG. 7]

REFERENCE VALUE COMPUTATION SECTION
$\beta = SOHR = R/Ri$

SOHR MAP

| T | | SOC | | |
|---|---|---|---|---|
| | | 80% | 50% | 30% |
| | 45°C | *** | *** | *** |
| | 25°C | *** | *** | *** |
| | 0°C | *** | *** | *** |
| | -10°C | *** | *** | *** |
| | -30°C | *** | *** | *** |

CORRECTION COEFFICIENT MAP ($\alpha$ MAP)

| T | | SOC | | |
|---|---|---|---|---|
| | | 80% | 50% | 30% |
| | 45°C | *** | *** | *** |
| | 25°C | *** | *** | *** |
| | 0°C | *** | *** | *** |
| | -10°C | *** | *** | *** |
| | -30°C | *** | *** | *** |

DCR MAP

| T | | SOC | | |
|---|---|---|---|---|
| | | 80% | 50% | 30% |
| | 45°C | *** | *** | *** |
| | 25°C | *** | *** | *** |
| | 0°C | *** | *** | *** |
| | -10°C | *** | *** | *** |
| | -30°C | *** | *** | *** |

REFERENCE RESISTANCE VALUE COMPUTATION SECTION

R, T, SOC

T, SOC

315 154 151 150 155 358 357 356

Ri β

EP 4 786 997 A1

## [FIG. 8]

*R, T, SOC* →

**REFERENCE VALUE COMPUTATION SECTION**
β1 = R
451

β1

**DCR MAP** — 358

| T | SOC | | |
|---|---|---|---|
| | 80% | 50% | 30% |
| 45°C | *** | *** | *** |
| 25°C | *** | *** | *** |
| 0°C | *** | *** | *** |
| -10°C | *** | *** | *** |
| -30°C | *** | *** | *** |

× 455

**CORRECTION COEFFICIENT MAP (α MAP)** — 154, 415

| T | SOC | | |
|---|---|---|---|
| | 80% | 50% | 30% |
| 45°C | *** | *** | *** |
| 25°C | *** | *** | *** |
| 0°C | *** | *** | *** |
| -10°C | *** | *** | *** |
| -30°C | *** | *** | *** |

÷ 457

*T, SOC* →

**REFERENCE RESISTANCE VALUE COMPUTATION SECTION** — 356

**SOHR MAP** — 150

| T | SOC | | |
|---|---|---|---|
| | 80% | 50% | 30% |
| 45°C | *** | *** | *** |
| 25°C | *** | *** | *** |
| 0°C | *** | *** | *** |
| -10°C | *** | *** | *** |
| -30°C | *** | *** | *** |

[FIG. 9]

*R, T, SOC*

REFERENCE VALUE
COMPUTATION SECTION
$\beta = SOHR = R/Ri$

151

$\beta$

REFERENCE VALUE
COMPARISON SECTION
$\beta - \beta m > \Delta\beta 0$ ?

152

515

SOHR MAP

150A

| | | SOC | | |
|---|---|---|---|---|
| | | 80% | 50% | 30% |
| T | 45°C | 120 | 125 | 125 |
| | 25°C | 125 | 125 | 125 |
| | 0°C | 115 | 120 | 110 |
| | -10°C | 115 | 120 | 100 |
| | -30°C | 110 | 120 | 100 |

CORRECTION COEFFICIENT
COMPUTATION SECTION
$\alpha 1 = \beta / \beta m$

559

SOHR MAP

150B

| | | SOC | | |
|---|---|---|---|---|
| | | 80% | 50% | 30% |
| T | 45°C | 125 | 130 | 130 |
| | 25°C | 130 | 130 | 130 |
| | 0°C | 120 | 125 | 110 |
| | -10°C | 120 | 125 | 100 |
| | -30°C | 110 | 125 | 100 |

$\alpha 1$

×

555

EP 4 786 997 A1

## INTERNATIONAL SEARCH REPORT

| International application No. |
| --- |
| **PCT/JP2025/012776** |

### A. CLASSIFICATION OF SUBJECT MATTER

***G01R 31/392***(2019.01)i; ***G01R 31/367***(2019.01)i; ***G01R 31/382***(2019.01)i; ***G01R 31/385***(2019.01)i; ***H01M 10/42***(2006.01)i; ***H01M 10/48***(2006.01)i

FI:    G01R31/392; G01R31/367; G01R31/382; G01R31/385; H01M10/42 P; H01M10/48 P; H01M10/48 301

According to International Patent Classification (IPC) or to both national classification and IPC

### B. FIELDS SEARCHED

Minimum documentation searched (classification system followed by classification symbols)

G01R31/36-31/396; H01M10/42-10/48; H02J7/00; B60L50/00-58/40; B60R16/00-16/08

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2022/259761 A1 (HITACHI, LTD.) 15 December 2022 (2022-12-15) paragraphs [0004], [0009]-[0096], [0145], fig. 1-16 | 1, 10-11, 14-15 |
| A | | 2-9, 12-13 |
| A | JP 2016-215836 A (HINO MOTORS, LTD.) 22 December 2016 (2016-12-22) entire text | 1-15 |
| A | JP 2020-514757 A (LG CHEM, LTD.) 21 May 2020 (2020-05-21) entire text | 1-15 |
| A | WO 2021/157120 A1 (VEHICLE ENERGY JAPAN INC.) 12 August 2021 (2021-08-12) entire text | 1-15 |
| A | US 12032035 B1 (STELLANTIS AUTO S.A.S.) 09 July 2024 (2024-07-09) entire text | 1-15 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **14 May 2025** | **03 June 2025** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
**Information on patent family members**

International application No.

**PCT/JP2025/012776**

| Patent document cited in search report | | | Publication date (day/month/year) | Patent family member(s) | | | Publication date (day/month/year) |
|---|---|---|---|---|---|---|---|
| WO | 2022/259761 | A1 | 15 December 2022 | EP | 4354689 | A1 | |
| | | | | paragraphs [0004], [0009]-[0122], [0192], fig. 1-16 | | | |
| | | | | JP | 2022-188638 | A | |
| JP | 2016-215836 | A | 22 December 2016 | (Family: none) | | | |
| JP | 2020-514757 | A | 21 May 2020 | US | 2021/0103001 | A1 | |
| | | | | WO | 2019/098722 | A1 | |
| | | | | EP | 3605127 | A1 | |
| | | | | KR | 10-2019-0056743 | A | |
| | | | | CN | 110462414 | A | |
| WO | 2021/157120 | A1 | 12 August 2021 | US | 2024/0183912 | A1 | |
| | | | | EP | 4102612 | A1 | |
| | | | | CN | 115427825 | A | |
| | | | | JP | 7381617 | B2 | |
| US | 12032035 | B1 | 09 July 2024 | WO | 2022/258895 | A1 | |
| | | | | FR | 3123992 | A1 | |
| | | | | CN | 117730261 | A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008241246 A